# EUROPEAN PATENT SPECIFICATION

(11) **EP 2 458 655 B1**
(45) Date of publication and mention of the grant of the patent: **21.04.2021**
(21) Application number: 11190050.2
(22) Date of filing: 22.11.2011
(51) Int. Cl.: H01L 33/48, H01L 33/62, H01L 33/64

(54) **Light emitting device package**
Gehäuse für eine lichtemittierende Vorrichtung
Boîtier incorporant un dispositif électroluminescent

(30) Priority: 25.11.2010 KR 20100118125
(43) Date of publication of application: 30.05.2012
(73) Proprietor: LG Innotek Co., Ltd., Seoul, 04637 (KR)
(72) Inventor: Jin, Hongboem, 100-714 Seoul (KR)
(74) Representative: M. Zardi & Co S.A.

(56) References cited:
- WO-A1-2008/002088
- JP-A- 2006 318 995
- JP-A- 2008 108 836
- JP-A- 2010 171 073
- US-A1- 2006 043 401
- US-A1- 2006 097 366
- US-A1- 2006 133 044
- US-A1- 2009 267 104
- US-A1- 2010 001 308
- US-A1- 2010 127 302
- US-B1- 6 848 819

## Description

### CROSS-REFERENCE TO RELATED APPLICATION

This application claims the priority benefit of Korean Patent Application No. 10-2010-0118125, filed on November 25, 2010 in the Korean Intellectual Property Office.

### BACKGROUND

### 1. Field

Embodiments relate to a light emitting device package.

### 2. Description of the Related Art

A light emitting diode (LED) is a device, which converts an electrical signal into light, using the characteristics of a compound semiconductor. Such an LED is applied to home electronic appliances, remote controllers, advertising display panels, indicators, various automation appliances, etc. The application range of LEDs is being gradually widened.

Meanwhile, when electricity is applied to a light emitting device package, a considerable amount of heat is generated from the light emitting device package. This heat not only degrades the durability and reliability of the light emitting device package, but also limits the functions and lifespan of the light emitting device package.

US 2010 001308A1 discloses a side view light emitting diode package including a housing that includes a front side part and a rear side part integrally formed with the front side part, the front side part having a light emission part; and a lead frame that is located between the front side part and the rear side part. US 2006 043401 A1 discloses a high power LED package, in which a package body is integrally formed with resin to have a recess for receiving an LED chip. US 2006 133044 A1 discloses a leadframe that is configured to be used with an electronic device, e.g., light emitting diode (LED), including a heat sink supporting ring for supporting a heat sink, where an outer frame is spaced apart from the heat sink supporting ring, and encloses the heat sink supporting ring. JP 2008 108836 A discloses a semiconductor light emitting device including a light emitting element, a lead frame where the light emitting element is mounted on a main surface thereof, a first resin part forming a reflecting surface for reflecting the light beam from the light emitting element, and a second resin part for fixing the lead frame. JP 2006 318995 A discloses stacked light emitting diode formed by connecting a plurality of reflective light emitting diode units that are respectively formed by placing a light emitting diode in opposite arrangement and a dichroic mirror in a metallic hollow holder case with high thermal conductivity. Further light emitting device packages of the prior art are disclosed in document WO 2008/002088 A1.

### SUMMARY

Embodiments provide a light emitting device package including a lead frame having a lateral extension to increase an exposed portion of the lead frame, and thus to enhance the heat sink function and heat dissipation function of the lead frame, thereby being capable of exhibiting more excellent heat dissipation effects and achieving an enhancement in reliability. Embodiments of the invention are defined in the independent claim 1. Further preferred embodiments of the invention are defined in the dependent claims.

In one embodiment, a light emitting device package includes a body comprising a cavity, and a recess formed at a bottom surface of the body, first and second lead frames mounted in the body, and a light source electrically connected with the first and second lead frames, wherein each of the first and second lead frames has a heat sink which is extended from a portion of the first or the second lead frames, and is disposed in the recess, wherein the body further comprises a second coupler formed on at least a portion of the body, and wherein the heat sink comprises a first coupler, to which the second coupler is coupled. The heat sink is contacted at least a portion of one side surface of the body.

The heat sink has at least a portion contacting the recess.

The heat sink may have at least one bent portion.

The bent portion may be disposed at a corner region of the body.

The bent portion may have a rounded portion.

The heat sink is extended from the first lead frame. The light source is mounted on the first lead frame.

The first lead frame may form an anode terminal.

The recess has a width greater than a width of the heat sink.

The recess has a depth greater than a thickness of the heat sink.

In examples not forming part of the claimed invention, the first coupler may be a groove, and the second coupler may be a protrusion to be coupled with the groove.

The first coupler is a protrusion, and the second coupler is a groove to be coupled with the protrusion.

The heat sink may has a hole through at least a portion of the heat sink.

At least a portion of the body may be protruded through the hole.

The heat sink has at least a portion in which roughness are formed.

The heat sink may be made of an identical material to the first and second lead frames.

The light emitting device package may further include a bonding layer disposed between at least one side surface of the body and the heat sink.

The heat sink may include a coating layer formed on at least a portion of a surface of the heat sink.

### BRIEF DESCRIPTION OF THE DRAWINGS

Details of embodiments will be more clearly understood from the following detailed description taken in conjunction with the accompanying drawings, in which:
FIG. 1 is a perspective view illustrating a light emitting device package according to an exemplary embodiment of the present invention;
FIG. 2 is a cross-sectional view illustrating the light emitting device package shown in FIG. 1;
FIG. 3 is a cross-sectional view illustrating the light emitting device package shown in FIG. 1;
FIG. 4 is a cross-sectional view illustrating a light emitting device package according to another embodiment;
FIG. 5 is a cross-sectional view illustrating a light emitting device package according to another embodiment;
FIG. 6 is a perspective view illustrating a light emitting device package according to another embodiment;
FIG. 7A is a perspective view illustrating a lighting apparatus including a light emitting device package according to an exemplary embodiment;
FIG. 7B is a cross-sectional view illustrating the lighting apparatus shown in FIG. 7A;
FIG. 8 is an exploded perspective view illustrating a liquid crystal display apparatus including a light emitting device according to an exemplary embodiment; and
FIG. 9 is an exploded perspective view illustrating a liquid crystal display apparatus including a light emitting device according to another embodiment.

### DETAILED DESCRIPTION OF EMBODIMENTS

Reference will now be made in detail to embodiments, examples of which are illustrated in the accompanying drawings. In the drawings, the thickness or size of each layer is exaggerated, omitted, or schematically illustrated for convenience of description and clarity. Also, the size or area of each constituent element does not entirely reflect the actual size thereof. Wherever possible, the same reference numbers will be used throughout the drawings to refer to the same or like parts.

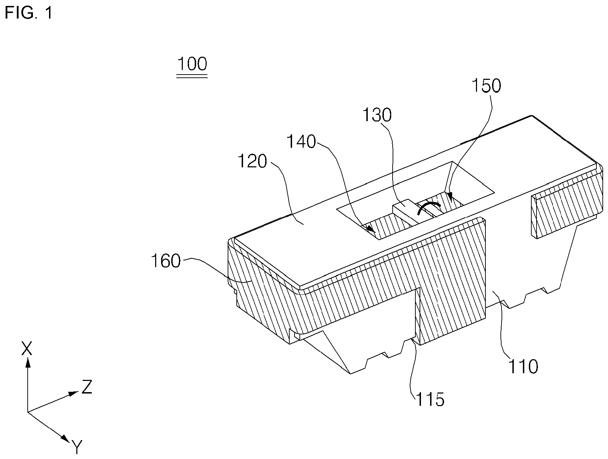

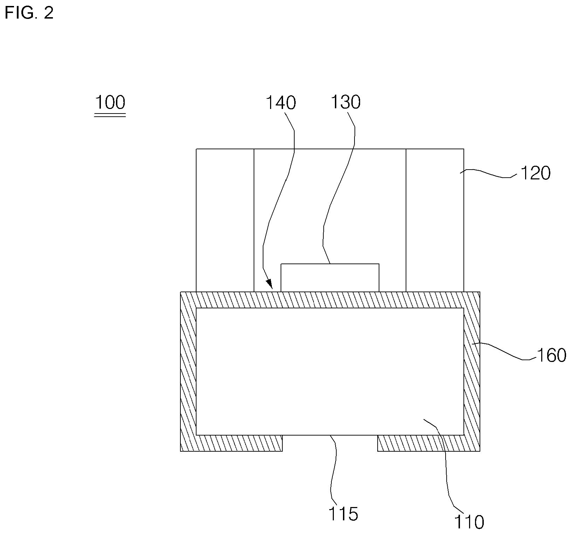

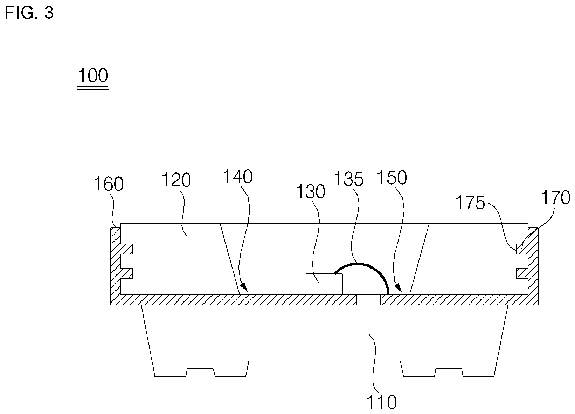

FIG. 1 is a perspective view illustrating a light emitting device package according to an exemplary embodiment of the present invention. FIG. 2 is a cross-sectional view illustrating the light emitting device package shown in FIG. 1. FIG. 3 is a cross-sectional view taken along a plane perpendicular to the plane of FIG. 2, illustrating the light emitting device package shown in FIG. 1.

In the following description, to explain the shape of the light emitting device package according to the illustrated embodiment in more detail, a longitudinal direction of the light emitting device package is referred to as a "longitudinal direction Z", a horizontal direction perpendicular to the longitudinal direction Z is referred to as a "horizontal direction Y", and a height direction perpendicular to both the longitudinal direction Z and the horizontal direction Y is referred to as a "height direction X".

That is, FIG. 2 is a cross-sectional view taken along an X-Y plane of the light emitting device package shown in FIG. 1, and viewed in the longitudinal direction Z, and FIG. 3 is a cross-sectional view taken along a Z-X plane of the light emitting device package shown in FIG. 1, and viewed in the horizontal direction Y.

Referring to FIGS. 1 to 3, the light emitting device package according to the illustrated embodiment, which is designated by reference numeral "100", includes a body 110 having a cavity while being provided, at a bottom surface thereof, with a recess 115, first and second lead frames 140 and 150 mounted in the cavity of the body 110, and a light source 130 mounted in the cavity of the body 110 while being electrically connected with the light source 130, wherein each one of the first and second lead frames 140 and 150 has a heat sink 160 which is extended from a portion of the first or the second lead frames 140 and 150, and the heat sink extending from the first lead frame 140 is disposed in the recess 115. The body 110 includes a second coupler 175 formed on at least a portion of the body 110. The heat sink 160 includes a first coupler 170, to which the second coupler 175 is coupled.

The body 110 may be made of at least one selected from among a resin such as Polyphthalamide (PPA), silicon (Si), aluminum (Al), aluminum nitride (AIN), a liquid crystal polymer such as photosensitive glass (PSG), polyamide 9T (PA9T), sindiotactic polystyrene (SPS), a metal, sapphire (Al₂O₃), and beryllium oxide (BeO), or may be a printed circuit board (PCB). The body 110 may be formed by an injection molding process, an etching process or the like, although the present disclosure is not limited thereto.

The body 110 may have an inclined surface at an inner surface thereof. In accordance with the inclination of the inclined surface, the reflection angle of light emitted from the light source 130 may be varied. Thus, the orientation angle of outwardly emitted light may be adjusted.

The smaller the orientation angle of light, the greater the convergence of light emitted from the light source 130 to the outside. Conversely, the greater the orientation angle of light, the smaller the convergence of light emitted from the light source 130 to the outside.

When viewing the cavity formed in the body 110 from the top side, the cavity may have a circular, square, polygonal, elliptical shape or the like and may have rounded corners. Of course, the cavity is not limited to the above-described shapes.

The light source 130 is electrically connected to the first and second lead frames 140 and 150. For example, the light source 130 may be wire-bonded to the first and second lead frames 140 and 150 by a wire 135.

The light source 130 may be, for example, a colored light emitting diode to emit red, green, blue and white light, or an ultraviolet (UV) light emitting diode to emit ultraviolet light, although the present disclosure is not limited thereto. One or more light emitting diodes may be mounted.

The light emitting diode may be of a horizontal type wherein all electric terminals are disposed on an upper surface thereof, or of a vertical type wherein electric terminals are distributed on upper and lower surfaces thereof. Alternatively, the light emitting diode may be of a flip-chip type.

A resin encapsulator (not shown) may fill the cavity, to cover the light source 130.

The resin encapsulator (not shown) may be made of silicon, epoxy resin, or other resin materials. The resin encapsulator may be formed by filling the cavity with an encapsulating material, and curing the filled material using ultraviolet light or heat.

The resin encapsulator (not shown) may include a fluorescent substance. The kind of the fluorescent substance may be selected in accordance with the wavelength of light emitted from the light source 130 in order to realize emission of white light.

The fluorescent substance may be a blue, bluish green, green, yellowish green, yellow, yellowish red, orange, or red light-emitting fluorescent substance in accordance with the wavelength of light emitted from the light source 130, although the present disclosure is not limited thereto.

That is, the fluorescent substance may be excited by light emitted from the light source 130 at a first wavelength, to generate light of a second wavelength. For example, when the light source 130 is a blue light emitting diode, and the fluorescent substance is a yellow fluorescent substance, the yellow fluorescent substance is excited by blue light, thereby emitting yellow light. In this case, the light emitting device package 100 may provide white light as the blue light generated from the blue light emitting diode and the yellow light generated in accordance with excitation by the blue light are mixed.

Similarly, when the light source 130 is a green light emitting diode, a magenta fluorescent substance or a mixture of blue and red fluorescent substances may be used as the fluorescent substance. Also, when the light source 130 is a red light emitting diode, a cyan fluorescent substance or a mixture of blue and green fluorescent substances may be used as the fluorescent substance.

The fluorescent substance may be a known fluorescent substance such as a YAG-based, TAG-based, sulfide-based, silicate-based, aluminate-based, nitride-based, carbide-based, nitridosilicate-based, borate-based, fluoride-based, or phosphate-based fluorescent substance.

The first and second lead frames 140 and 150 may be made of at least one of titanium (Ti), copper (Cu), nickel (Ni), gold (Au), chromium (Cr), tantalum (Ta), platinum (Pt), tin (Sn), silver (Ag), phosphor (P), aluminum (Al), indium (In), palladium (Pd), cobalt (Co), silicon (Si), germanium (Ge), hafnium (Hf), ruthenium (Ru), and iron (Fe), or an alloy thereof. The first and second lead frames 140 and 150 may have a single-layer structure or a multilayer structure, although the present disclosure is not limited thereto.

The first and second lead frames 140 and 150 are spaced apart from each other, to be electrically isolated from each other. The first lead frame 140 directly contacts the light source 130 or in an embodiment not forming part of the claimed invention, it may be electrically connected to the light source 130 via a material having conductivity. One of the first and second lead frames 140 and 150 may function as an anode terminal, and the other of the first and second lead frames 140 and 150 may function as a cathode terminal. Also, the second lead frame 150 may be electrically connected to the light source 130 by the wire 135, although the present disclosure is not limited thereto. Accordingly, as a power source is connected to the first and second lead frames 140 and 150, electricity may be applied to the light source 130. Meanwhile, a plurality of lead frames (not shown) are mounted in the body 110, and each of the lead frames (not shown) is electrically connected to associated ones of a plurality of light sources.

The first lead frame 140 has a heat sink 160 extended externally from the body 110 in the longitudinal direction Z of the body 110. Each one of the first and second lead frames 140 and 150 has a longitudinal extension to form the heat sink 160. The extension is bent to connect side surfaces of the body 110. Alternatively, in an example not forming part of the claimed invention, a separate member (not shown) may be coupled to the first and second lead frames 140 and 150 such that it connects at least one side surface of the body 110. Alternatively, in an example not forming part of the claimed invention, a material such as a resin material having thermal conductivity may be coated over the side surfaces of the body 110. Of course, the present disclosure is not limited to the above-described structures.

Meanwhile, the heat sink 160 may be made of the same material as the first and second lead frames 140 and 150, although the present disclosure is not limited thereto. That is, the heat sink may be made of at least one of titanium (Ti), copper (Cu), nickel (Ni), gold (Au), chromium (Cr), tantalum (Ta), platinum (Pt), tin (Sn), silver (Ag), phosphor (P), aluminum (Al), indium (In), palladium (Pd), cobalt (Co), silicon (Si), germanium (Ge), hafnium (Hf), ruthenium (Ru), and iron (Fe), or an alloy thereof, although the present disclosure is not limited thereto.

Although the heat sink 160 is illustrated as extending from the first lead frame 140, as shown in FIG. 3, it is formed to extend from each one of the first and second lead frames 140 and 150. A plurality of lead frames (not shown) may be formed, and a plurality of heat sinks 160 may extend from selected ones of the lead frames, although the present disclosure is not limited thereto.

Meanwhile, the heat sink 160 is formed at the first lead frame 140, on which the light source 130 is mounted. In accordance with this structure, it may be possible to more effectively transfer heat generated in the light source 130 to the heat sink 160. Accordingly, the heat dissipation function of the light emitting device package 100 may be further enhanced.

The heat sink 160 may be formed at the anode terminal. Since heat dissipation of the light emitting device package 100 is mainly carried out at the anode terminal, it may be possible to more effectively achieve an increase in the heat dissipation effects of the light emitting device package 100.

The heat sink 160 includes a bent portion to bring the heat sink 160 into connect with the side surfaces of the body 110, respectively. A bent portion may have a rounded portion. The bent portion may be formed at corner regions of the body 110, respectively.

Since the heat sink 160 is formed to extend from the first and second lead frames 140 and 150 while extending along side surfaces of wall portions 120 of the body 110, it may be possible to further increase the exposed areas and volumes of the first and second lead frames 140 and 150, and thus to enhance the heat sink functions and heat dissipation functions of the first and second lead frames 140 and 150. Accordingly, it may be possible to achieve an enhancement in the reliability of the light emitting device package 100.

Meanwhile, the heat sink 160 of the first lead frame 140 is bent to extend along the bottom surface of the body 110. As described above, the body 110 is provided, at the bottom surface thereof, with the recess 115 to receive the extension portion of the heat sink 160. As the body 110 is provided with the recess 115, and the heat sink 160 is partially received in the recess 115, it may be possible to more stably form the heat sink 160.

The recess 115 has a depth greater than the thickness of the heat sink 160, and a width greater than the width of the heat sink 160, in order to allow the heat sink 160 to be more easily received in the recess 115.

As the body 110 includes the recess 115, and the heat sink 160 is disposed in the recess 115, it may be possible to more reliably fix the heat sink 160 to the body 110.

Meanwhile, referring to FIG. 3, the heat sink 160 includes the first coupler 170, and the body 110 includes the second coupler 175. The first coupler 170 is formed at an inner surface of the heat sink 160 connecting the body 110. The first coupler 170 includes at least one protrusion. The second coupler 175 is formed to be engagable with the first coupler 170. The second coupler 175 includes at least one groove. Meanwhile, in an example not forming part of the claimed invention, the second coupler 175 may have a structure different from the illustrated structure, for example, a hole structure, so long as it may be coupled with the first coupler 170. Of course, the present disclosure is not limited to the above-described structures.

Although the first coupler 170, which includes protrusions, is formed at the heat sink 160, and the second coupler 175, which includes grooves, in order to correspond to the first coupler 170, is formed at the body 110, in the case of FIG. 3, the present disclosure is not limited thereto. In examples not forming part of the claimed invention, reversed structures may be employed. That is, protrusions (not shown) may be formed on at least a portion of the body 110, and grooves (not shown) corresponding to the protrusions (not shown) may be formed in at least a portion of the heat sink 160.

As the heat sink 160 is provided with the first coupler 170, and the body 110 is provided with the second coupler 175 corresponding to the first coupler 170, it may be possible to more reliably fix the heat sink 160 to the body 110.

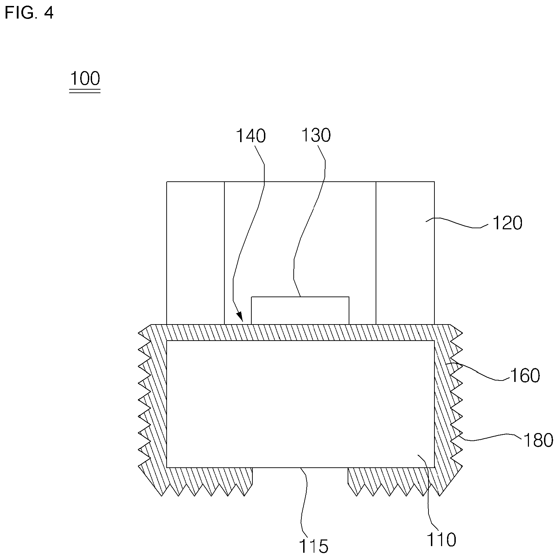

FIG. 4 is a cross-sectional view illustrating a light emitting device package according to another embodiment.

Referring to FIG. 4, the heat sink 160 includes roughness 180 formed on at least a portion of the heat sink 160. The roughness 180 is formed on an outer surface of the heat sink 160, although the present disclosure is not limited thereto.

As the heat sink 160 includes the roughness (not shown), it may be possible to increase the surface area of the heat sink 160, and thus to achieve an enhancement in the heat dissipation effects of the heat sink 160.

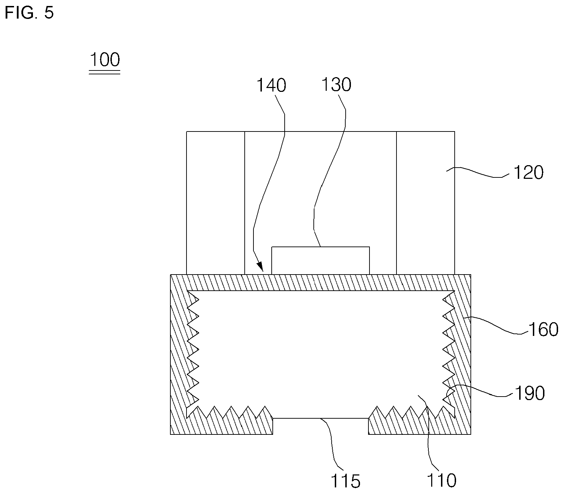

FIG. 5 is a cross-sectional view illustrating a light emitting device package according to another embodiment.

Referring to FIG. 5, a bonding layer 190 may be disposed between at least one surface of the body 110 and the heat sink 160.

As the bonding layer 190 is disposed between the body 110 and the heat sink 160, it may be possible to reliably fix the heat sink 160 to the body 110. The bonding layer 190 may be formed by coating a material of the bonding layer 190 over one side surface of the body 110, disposing the heat sink 160 to contact the coated bonding layer (not shown), and then curing the coated bonding layer (not shown), although the present disclosure is not limited thereto.

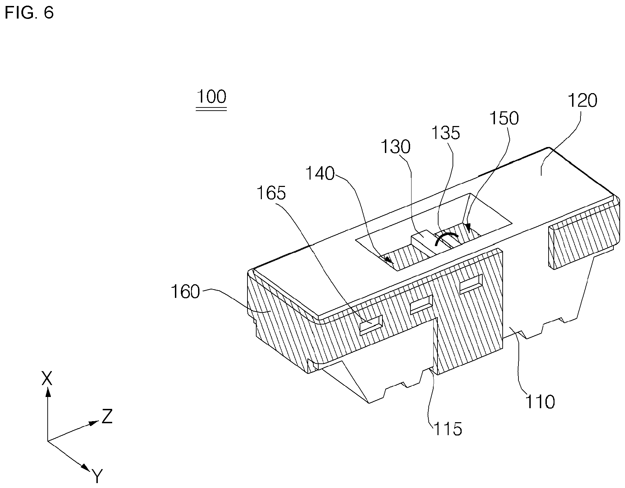

FIG. 6 is a perspective view illustrating a light emitting device package according to another embodiment.

Referring to FIG. 6, the heat sink 160 may have holes 165.

The holes 165 may be formed by etching or pressing the heat sink 160, or preparing the first and second lead frames 140 and 150 to have the holes 165, although the present disclosure is not limited thereto. Although a plurality of holes 165 having a rectangular shape is formed at the heat sink 160, which is connected to the first lead frame 140, in the case of FIG. 6, the holes 165 may be formed at the heat sink 160, which is connected to the second lead frame 150. Also, the holes 165 may have other shapes, for example, a circular shape or a polygonal shape, although the present disclosure is not limited thereto.

Meanwhile, a portion of the body 110 may be protruded into at least one of the holes 165, or at least one of the holes 165 may be filled with a portion of the body 110, although the present disclosure is not limited thereto.

As the holes 165 are formed at the heat sink 160, the exposed area of the heat sink 160 increases, thereby enhancing the heat sink function and heat dissipation effects of the heat sink 160. Thus, an enhancement in the reliability of the light emitting device package 100 may be achieved.

The light emitting device package according to any one of the above-described embodiments may be applied to a lighting system. The lighting system may be a lighting apparatus, in an embodiment of the claimed invention the lighting system is a backlight unit, examples not forming part of the claimed invention include a liquid crystal display device, etc, although the present disclosure is not limited thereto.

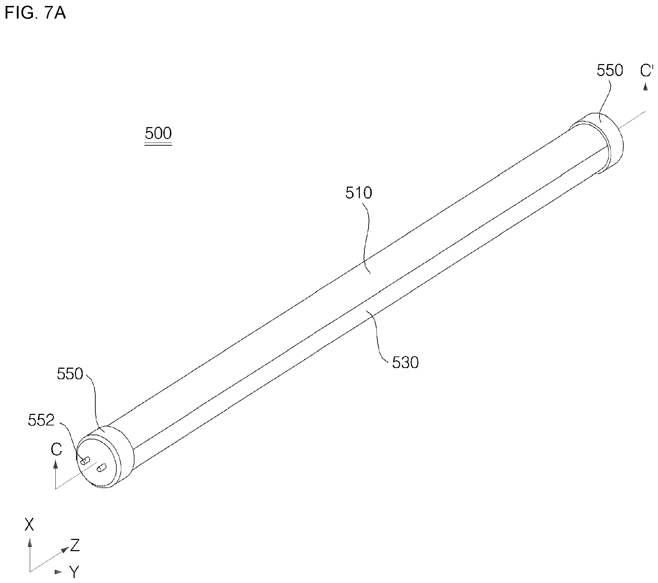

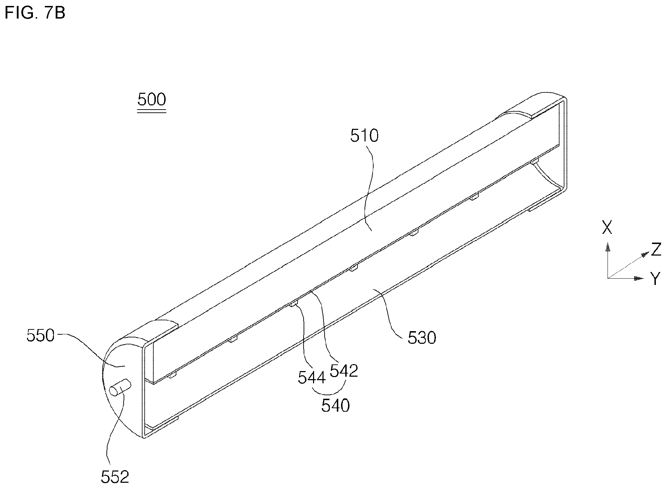

FIG. 7A is a perspective view illustrating a lighting apparatus including a light emitting device package according to an exemplary embodiment. FIG. 7B is a cross-sectional view taken along a plane extending in a longitudinal direction Z and a height direction X and viewed in a horizontal direction Y, illustrating the lighting apparatus of FIG. 7A.

Referring to FIGS. 7A and 7B, the lighting apparatus, which is designated by reference numeral "500" may include a body 510, a cover 530 coupled to the body 510, and end caps 550 located at both ends of the body 510.

A light emitting device module 540 is coupled to a lower surface of the body 510. The body 510 may be made of a metal material exhibiting excellent conductivity and excellent heat radiation effects to outwardly dissipate heat generated from light emitting device packages 544 through an upper surface of the body 510.

The light emitting device packages 544 may be mounted on a printed circuit board (PCB) 542 in multiple rows while having various colors, to form a multi-color array. The light emitting device packages 544 may be mounted at the same distance, or may be mounted at different distances to enable brightness adjustment, if necessary. The PCB 542 may be a metal core PCB (MCPCB) or a PCB made of a flame retardant-4 (FR4) material.

Each light emitting device package 544 may include a heat sink (not shown) so that it may have an enhanced heat dissipation function. Thus, it may be possible to enhance the reliability and efficiency of the light emitting device package 544. In addition, it may be possible to extend the life span of the lighting apparatus 500, which includes the light emitting device packages 544.

The cover 530 may have a circular shape to surround the lower surface of the body 510, although the present disclosure is not limited thereto.

The cover 530 protects the light emitting device module 540 from external foreign matter, etc. The cover 530 may contain light diffusion particles to achieve anti-glare effects and uniform emission of light generated from the light emitting device packages 544. At least one of the inner and outer surfaces of the cover 530 may be provided with a prism pattern. Also, a fluorescent substance layer may be coated over at least one of the inner and outer surfaces of the cover 530.

Since the light generated from the light emitting device packages 544 is outwardly emitted through the cover 530, the cover 530 should have high light transmittance and heat resistance sufficient to endure heat generated from the light emitting device packages 544. To this end, the cover 530 may be formed of polyethylene terephthalate (PET), polycarbonate (PC) or polymethylmethacrylate (PMMA).

The end caps 550 may be disposed at both ends of the body 510 and function to seal a power supply device (not shown). Each end cap 550 is provided with power pins 552, so that the lighting apparatus 500 in accordance with the illustrated embodiment may be directly connected to a terminal, which is provided for a conventional fluorescent lamp, without an additional connector.

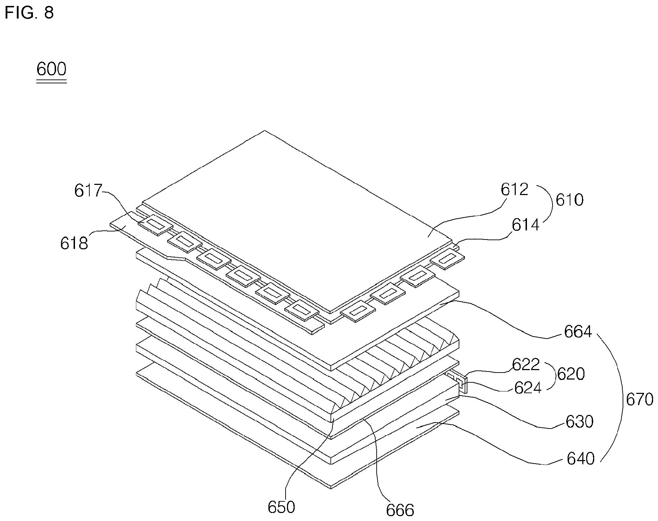

FIG. 8 is an exploded perspective view illustrating a liquid crystal display apparatus including a light emitting device according to an exemplary embodiment.

FIG. 8 illustrates an edge-light type liquid crystal display apparatus 600. The liquid crystal display apparatus 600 may include a liquid crystal display panel 610 and a backlight unit 670 to supply light to the liquid crystal display panel 610.

The liquid crystal display panel 610 may display an image using the light supplied from the backlight unit 670. The liquid crystal display panel 610 may include a color filter substrate 612 and a thin film transistor substrate 614, which are opposite each other with liquid crystals interposed therebetween.

The color filter substrate 612 may realize the color of an image displayed on the liquid crystal display panel 610.

The thin film transistor substrate 614 is electrically connected to a PCB 618, on which a plurality of circuit elements is mounted, by means of a drive film 617. The thin film transistor substrate 614 may apply drive voltage provided by the PCB 618 to liquid crystals in response to a drive signal transmitted from the PCB 618.

The thin film transistor substrate 614 may include thin film transistors and pixel electrodes in the form of thin films formed on another substrate made of a transparent material such as glass or plastic.

The backlight unit 670 includes a light emitting device module 620 to emit light, a light guide plate 630 to change light emitted from the light emitting device module 620 into planar light and to transmit the planar light to the liquid crystal display panel 610, a plurality of films 650, 666 and 664 to achieve uniformity in brightness distribution and improved vertical incidence of light emerging from the light guide plate 630, and a reflection sheet 640 to reflect light emitted rearwards from the light guide plate 630 toward the light guide plate 630.

The light emitting device module 620 may include a plurality of light emitting device packages 624 and a PCB 622 on which the plurality of light emitting device packages 624 is mounted to form an array.

In particular, each light emitting device package 624 may include a heat sink (not shown) so that it may have an enhanced heat dissipation function. Thus, it may be possible to enhance the reliability and efficiency of the light emitting device package 624. In addition, it may be possible to extend the life span of the lighting apparatus 600, which includes the light emitting device packages 624.

Meanwhile, the backlight unit 670 may include a diffusion film 666 to diffuse light incident thereupon from the light guide plate 630 toward the liquid crystal display panel 610, and a prism film 650 to condense the diffused light so as to enhance vertical light incidence. The backlight unit 670 may further include a protection film 664 to protect the prism film 650.

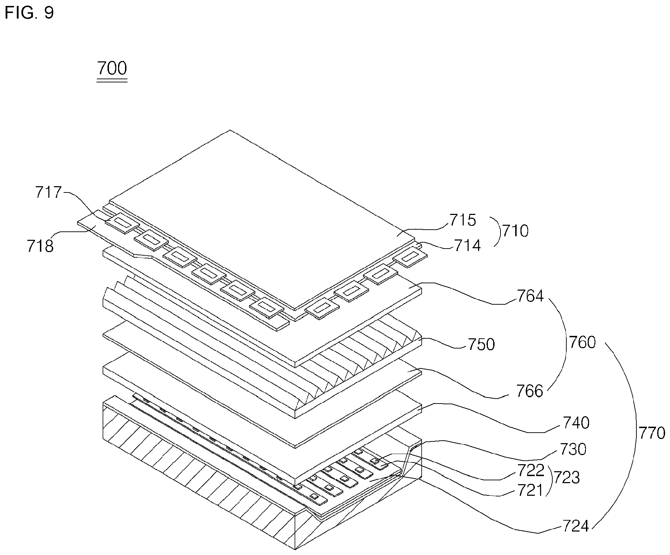

FIG. 9 is an exploded perspective view illustrating a liquid crystal display apparatus including a light emitting device according to another embodiment. The same configuration as that illustrated in FIG. 8 and described with reference to FIG. 8 will not be repeatedly described in detail.

FIG. 9 illustrates a direct type liquid crystal display apparatus 700 including a liquid crystal display panel 710 and a backlight unit 770 to supply light to the liquid crystal display panel 710.

The liquid crystal display panel 710 is identical to that of FIG. 8 and, as such, no detailed description thereof will be given.

The backlight unit 770 may include a plurality of light emitting device modules 723, a reflection sheet 724, a lower chassis 730 in which the light emitting device modules 723 and reflection sheet 724 are accommodated, and a diffusion sheet 740 and a plurality of optical films 760, which are disposed over the light emitting device modules 723.

Each light emitting device module 723 may include a plurality of light emitting device packages 722, and a PCB 721 on which the plurality of light emitting device packages 722 is mounted to form an array.

In particular, each light emitting device package 722 may include a heat sink (not shown) so that it may have an enhanced heat dissipation function. Thus, it may be possible to enhance the reliability and efficiency of the light emitting device package 722. In addition, it may be possible to extend the life span of the backlight unit 770, which includes the light emitting device packages 722.

The reflection sheet 724 reflects light generated by the light emitting device packages 722 toward the liquid crystal display panel 710, to achieve an enhancement in light utilization efficiency.

Meanwhile, the light generated from the light emitting device modules 723 is incident upon the diffusion sheet 740. The optical films 760 are disposed over the diffusion sheet 740. The optical films 760 may include a diffusion film 766, a prism film 750 and a protection film 764.

As apparent from the above description, in the light emitting device package according to each of the above-described embodiments, the heat sink formed to extend from the lead frames extend along a side surface of the body, so that it may be possible to enhance the heat sink function and heat dissipation function of the lead frames. Accordingly, it may be possible to obtain more excellent heat dissipation effects and to achieve an enhancement in reliability.

Although embodiments have been described with reference to a number of illustrative embodiments thereof, it should be understood that numerous other modifications and applications may be devised by those skilled in the art that will fall within the intrinsic aspects of the embodiments. More particularly, various variations and modifications are possible in concrete constituent elements of the embodiments. The embodiments of the invention are defined in the appended claims.

## Claims

1. A light emitting device package (100) comprising:
a body (110) comprising a cavity surrounded by wall portions (120) having side surfaces;
first and second lead frames (140, 150) mounted in the body (110); and
a light emitting diode (130) electrically connected with the first and second lead frames (140, 150) disposed in the cavity;
wherein the light emitting diode (130) is disposed on the first lead frame (140) in the cavity,
wherein the first and second lead frames (140, 150) have a heat sink (160) which is extended, respectively, from a portion of the first and the second lead frames (140, 150) in the longitudinal direction (Z) of the body (110) while extending along side surfaces of the wall portions (120) of the body (110), and wherein the body (110) further comprises a recess (115) formed at a bottom surface of the body (110), and a portion of the heat sink (160) of the first lead frame (140) is bent to extend along the bottom surface of the body (110) and is disposed in the recess (115), the bottom surface arranged at the opposite to the light emission surface of the light emitting device package (100) with respect to the body (110), and
wherein the recess (115) has a width greater than a width of the heat sink (160), and the recess (115) has a depth greater than a thickness of the heat sink (160),
wherein the heat sink (160) further comprises a first coupler and the body (110) further comprises a second coupler (175), to which the first coupler is coupled,
wherein the first coupler is a protrusion (170) formed at an inner surface of the heat sink (160) which connects to the side surfaces of the wall portions (120) of the body (110); wherein the second coupler is a groove (175) formed in order to correspond to the first coupler, and wherein the heat sink (160) has at least a portion on an outer surface thereof on which roughness is formed such that an enhancement in the heat dissipation effect of the heat sink (160) is achieved.

2. The light emitting device package (100) according to claim 1, wherein the heat sink (160) is connected to at least a portion of one side surface of the body (110).

3. The light emitting device package (100) according to claim 1, wherein the heat sink (160) has at least a portion contacting the recess (115).

4. The light emitting device package (100) according to any one of claims 1 to 3, wherein the heat sink (160) has at least one bent portion, and
wherein the bent portion is disposed at a corner region of the body (110).

5. The light emitting device package (100) according to any one of claims 1 to 4, wherein the heat sink (160) has holes (165) through at least a portion of the heat sink (160), and wherein at least a portion of the body (110) is protruded through the holes (165).

6. The light emitting device package (100) according to any one of claims 1 to 5, further comprising:
a bonding layer disposed between at least one side surface of the body (110) and the heat sink (160).

7. A backlight unit comprising a light emitting device package (100) according to any one of claims 1 to 6.

## Patentansprüche

1. Lichtemittierungsvorrichtungsbaugruppe (100), umfassend:
einen Körper (110), der einen Hohlraum umfasst, der von Wandabschnitten (120) mit seitlichen Oberflächen umgeben ist;
erste und zweite Leiterrahmen (140, 150), die in dem Körper (110) angebracht sind; und
eine Leuchtdiode (130), die mit den in dem Hohlraum angeordneten ersten und zweiten Leiterrahmen (140, 150) elektrisch verbunden ist;
wobei die Leuchtdiode (130) auf dem ersten Leiterrahmen (140) in dem Hohlraum angeordnet ist,
wobei die ersten und zweiten Leiterrahmen (140, 150) eine Wärmesenke (160) aufweisen, die sich jeweils von einem Abschnitt der ersten und der zweiten Leiterrahmen (140, 150) in der Längsrichtung (Z) des Körpers (110) erstreckt, während sie sich entlang seitlicher Oberflächen der Wandabschnitte (120) des Körpers (110) erstreckt, und wobei der Körper (110) ferner eine Aussparung (115) umfasst, die an einer unteren Oberfläche des Körpers (110) ausgebildet ist, und ein Abschnitt der Wärmesenke (160) des ersten Leiterrahmens (140) gekrümmt ist, dass er sich entlang der unteren Oberfläche des Körpers (110) erstreckt und in der Aussparung (115) angeordnet ist, wobei die untere Oberfläche in Bezug auf den Körper (110) gegenüber der Lichtemissionsoberfläche der Lichtemittierungsvorrichtungsbaugruppe (100) angeordnet ist, und
wobei die Aussparung (115) eine Breite aufweist, die größer ist als eine Breite der Wärmesenke (160), und die Aussparung (115) eine Tiefe aufweist, die größer ist als eine Dicke der Wärmesenke (160),
wobei die Wärmesenke (160) ferner einen ersten Koppler umfasst und der Körper (110) ferner einen zweiten Koppler (175) umfasst, an den der erste Koppler gekoppelt ist,
wobei der erste Koppler ein Vorsprung (170) ist, der an einer inneren Oberfläche der Wärmesenke (160) ausgebildet ist, die mit den seitlichen Oberflächen der Wandabschnitte (120) des Körpers (110) verbunden ist; wobei der zweite Koppler eine Nut (175) ist, die ausgebildet ist, dass sie dem ersten Koppler entspricht, und wobei die Wärmesenke (160) wenigstens einen Abschnitt auf einer äußeren Oberfläche davon aufweist, auf dem eine Rauigkeit ausgebildet ist, so dass eine Verbesserung des Wärmeableitungseffekts der Wärmesenke (160) erreicht wird.

2. Lichtemittierungsvorrichtungsbaugruppe (100) nach Anspruch 1, wobei die Wärmesenke (160) mit wenigstens einem Abschnitt einer seitlichen Oberfläche des Körpers (110) verbunden ist.

3. Lichtemittierungsvorrichtungsbaugruppe (100) nach Anspruch 1, wobei die Wärmesenke (160) wenigstens einen Abschnitt aufweist, der die Aussparung (115) kontaktiert.

4. Lichtemittierungsvorrichtungsbaugruppe (100) nach einem der Ansprüche 1 bis 3, wobei die Wärmesenke (160) wenigstens einen gekrümmten Abschnitt aufweist, und
wobei der gekrümmte Abschnitt an einem Eckbereich des Körpers (110) angeordnet ist.

5. Lichtemittierungsvorrichtungsbaugruppe (100) nach einem der Ansprüche 1 bis 4, wobei die Wärmesenke (160) Löcher (165) durch wenigstens einen Abschnitt der Wärmesenke (160) aufweist, und wobei wenigstens ein Abschnitt des Körpers (110) durch die Löcher (165) vorsteht.

6. Lichtemittierungsvorrichtungsbaugruppe (100) nach einem der Ansprüche 1 bis 5, ferner umfassend:
eine Bondingschicht, die zwischen wenigstens einer seitlichen Oberfläche des Körpers (110) und der Wärmesenke (160) angeordnet ist.

7. Hintergrundbeleuchtungseinheit, umfassend eine Lichtemittierungsvorrichtungsbaugruppe (100) nach einem der Ansprüche 1 bis 6.

## Revendications

1. Un boîtier (100) de dispositif électroluminescent comprenant :
un corps (110) comprenant une cavité entourée par des parties de paroi (120) ayant des surfaces latérales ;
des premier et deuxième châssis conducteurs (140, 150) montés dans le corps (110) ; et
une diode électroluminescente (130) connectée électriquement aux premier et deuxième châssis conducteurs (140, 150), disposée dans la cavité ;
la diode électroluminescente (130) étant disposée sur le premier châssis conducteur (140) dans la cavité,
les premier et deuxième châssis conducteurs (140, 150) ayant un dissipateur de chaleur (160) qui s'étend, respectivement, à partir d'une partie des premier et deuxième châssis conducteurs (140, 150) dans la direction longitudinale (Z) du corps (110) tout en s'étendant le long de surfaces latérales des parties de paroi (120) du corps (110), et le corps (110) comprenant en outre un évidement (115) formé au niveau d'une surface inférieure du corps (110), et une partie du dissipateur thermique (160) du premier châssis conducteur (140) étant pliée de façon à s'étendre le long de la surface inférieure du corps (110) et étant disposée dans l'évidement (115), la surface inférieure étant disposée à l'opposé de la surface d'émission de lumière du boîtier (100) de dispositif électroluminescent par rapport au corps (110), et
l'évidement (115) ayant une largeur supérieure à une largeur du dissipateur de chaleur (160), et l'évidement (115) ayant une profondeur supérieure à une épaisseur du dissipateur de chaleur (160),
le dissipateur de chaleur (160) comprenant en outre un premier coupleur et le corps (110) comprenant en outre un deuxième coupleur (175), auquel le premier coupleur est couplé,
le premier coupleur étant une saillie (170) formée au niveau d'une surface interne du dissipateur thermique (160) qui est reliée aux surfaces latérales des parties de paroi (120) du corps (110) ; le deuxième coupleur étant une rainure (175) formée pour correspondre au premier coupleur,
le dissipateur thermique (160) ayant au moins, sur une surface externe de lui-même, une partie sur laquelle une rugosité est formée de telle sorte qu'une amélioration de l'effet de dissipation thermique du dissipateur thermique (160) est obtenue.

2. Le boîtier (100) de dispositif électroluminescent selon la revendication 1, dans lequel le dissipateur thermique (160) est relié à au moins une partie d'une surface latérale du corps (110).

3. Le boîtier (100) de dispositif électroluminescent selon la revendication 1, dans lequel le dissipateur thermique (160) a au moins une partie en contact avec l'évidement (115).

4. Le boîtier (100) de dispositif électroluminescent selon l'une quelconque des revendications 1 à 3, dans lequel le dissipateur thermique (160) a au moins une partie pliée, et
dans lequel la partie pliée est disposée dans une zone d'angle du corps (110).

5. Le boîtier (100) de dispositif électroluminescent selon l'une quelconque des revendications 1 à 4, dans lequel le dissipateur thermique (160) a des trous (165) à travers au moins une partie du dissipateur thermique (160), et dans lequel au moins un une partie du corps (110) fait saillie à travers les trous (165).

6. Le boîtier (100) de dispositif électroluminescent selon l'une quelconque des revendications 1 à 5, comprenant en outre :
une couche de liaison disposée entre au moins une surface latérale du corps (110) et le dissipateur thermique (160).

7. Une unité de rétroéclairage comprenant un boîtier (100) de dispositif électroluminescent selon l'une quelconque des revendications 1 à 6.
